**Europäisches Patentamt**

**European Patent Office**

**Office européen des brevets**

(11) Veröffentlichungsnummer: **0 285 926**
**A2**

(12) **EUROPÄISCHE PATENTANMELDUNG**

(21) Anmeldenummer: 88104806.0

(22) Anmeldetag: 25.03.88

(51) Int. Cl.⁴: **H03C 3/09**

(30) Priorität: 09.04.87 DE 3711983

(43) Veröffentlichungstag der Anmeldung:
**12.10.88 Patentblatt 88/41**

(84) Benannte Vertragsstaaten:
**CH DE FR GB IT LI**

(71) Anmelder: **GRUNDIG E.M.V.**
**Elektro-Mechanische Versuchsanstalt Max**
**Grundig holländ. Stiftung & Co. KG.**
**Kurgartenstrasse 37**
**D-8510 Fürth/Bay.(DE)**

(72) Erfinder: **Schülein,Reinhard,c/o Grundig**
**E.M.V.**
**Max Grundig holländ. Stiftung Co KG**
**Kurgartenstrasse 37,D-8510 Fürth/Bay.(DE)**
Erfinder: **Gwiosda, Horst c/o Grundig E.M.V.**
**Max Grundig Holländ.Stiftung Co KG**
**Kurgartenstrasse 37 D-8510 Fürth/Bay(DE)**

(54) **Verfahren zur Feinabstimmung eines HF-Modulators und Anordnung zur Durchführung des Verfahrens.**

(57) Bekannte Verfahren bzw. Anordnungen zur Abstimmung von in Videorecordern betriebenen HF-Modulatoren haben den Nachteil, daß sie entweder zu langsam und ungenau (Handabstimmung) oder im Hinblick auf die technische Realisierung zu aufwendig (PLL-Abstimmung) sind. Durch das neue Verfahren soll der technische Aufwand für eine Anordnung zur Durchführung des Verfahrens möglichst gering bleiben und dennoch eine schnelle und präzise Modulatorabstimmung gewährleistet sein.

Hierzu wird das Ausgangssignal des zum Modulator gehörenden spannungsgesteuerten Oszillators über den im Videorecorder ohnehin vorhandenen Tuner verstärkt und anschließend hinsichtlich des Pegels ausgewertet. In Abhängigkeit vom Pegel des verstärkten Oszillatorsignals wird dann ein Regelsignal gebildet, das die Abstimmung des Modulators verändert, bis der Pegel des verstärkten Oszillatorsignals ein Maximum erreicht.

Eine Anwendung des neuen Verfahrens ist insbesondere bei Videorecordern mit automatisch abgleichbaren Tunern von Vorteil.

# VERFAHREN ZUR FEINABSTIMMUNG EINES HF-MODULATORS UND ANORDNUNG ZUR DURCHFÜHRUNG DES VERFAHRENS

Die Erfindung betrifft ein Verfahren zur Feinabstimmung eines HF-Modulators, der in einem Videorecorder mit automatisch abgleichbarem Tuner betrieben wird und der zur Abstimmung einen spannungsgesteuerten Oszillator enthält, sowie eine Anordnung zur Durchführung des Verfahrens.

Zur Abstimmung des HF-Modulators in einem Videorecorder ist es bekannt, den hierzu vorgesehenen spannungsgesteuerten Oszillator entweder per Hand mit Hilfe eines Potentiometers oder automatisch mittels einer Regelschleife (PLL) abzugleichen. Beide Möglichkeiten haben jedoch Nachteile. So erfordert die Handabstimmung einen hohen Zeitaufwand und führt außerdem nur zu einem relativ groben Abgleich. Demgegenüber arbeitet die automatische Abstimmung mittels PLL-Schleife zwar schnell und sehr präzise, erfordert jedoch einen wesentlich höheren technischen und kostenmäßigen Aufwand.

Der Erfindung liegt die Aufgabe zugrunde, ein Verfahren der im Oberbegriff des Anspruchs 1 angegebenen Art so auszubilden, daß eine schnelle und präzise Modulatorabstimmung gewährleistet ist und dennoch nur ein geringer technischer Aufwand für eine Anordnung zur Durchführung des Verfahrens erforderlich ist.

Diese Aufgabe wird gemäß der Erfindung durch die im Kennzeichen des Anspruchs 1 angegebenen Maßnahmen gelöst. Ein Ausführungsbeispiel für eine Anordnung zur Durchführung des Verfahrens gemäß der Erfindung ist im Unteranspruch gekennzeichnet.

Bei dem Verfahren gemäß der Erfindung wird das Ausgangssignal des auf einen bestimmten Kanal eingestellten spannungsgesteuerten Oszillators über den entsprechend abgestimmten und abgeglichenen Tuner verstärkt. Anschließend wird der Pegel des verstärkten Oszillatorsignals ausgewertet und in Abhängigkeit hiervon ein Regelsignal gebildet, das die Abstimmung des Modulators solange verändert, bis der Pegel des verstärkten Oszillatorsignals ein Maximum erreicht.

Eine Anordnung zur Durchführung des Verfahrens gemäß der Erfindung ist im folgenden anhand einer Zeichnung näher erläutert.

Die dargestellte Blockschaltung zeigt einen abzustimmenden Modulator 6 mit einem spannungsgesteuerten Oszillator 2, dessen Ausgang über einen Signalweg 1 mit dem Eingang eines im Videorecorder ohnehin vorhandenen, vorzugsweise automatisch abgleichbaren Tuners 3 verbunden ist. Der Signalweg 1 ist bei dem hier gezeigten Beispiel als umschaltbarer Antennenverstärker ausgebildet, der es erlaubt, dem Tuner wahlweise das für die Modulatorabstimmung benötigte Oszillatorsignal, oder ein für den Empfang benötigtes Antennensignal zuzuführen. Ein Ausgang des Tuners 3 steht mit einem gleichfalls im Videorecorder bereits vorhandenen Mikrocomputer 4 in Verbindung, dessen Regelausgang über einen Digital-Analog-Converter 5 an den Steuereingang des Oszillators 2 angeschlossen ist.

Zunächst wird sowohl für den selbstabgleichenden Tuner 3 als auch für den Oszillator 2 der gleiche Kanal gewählt. Das zur dynamischen Modulatorfeinabstimmung über den abgeglichenen Tuner verstärkte Oszillatorsignal wird dann pegelmäßig im Mikrocomputer 4 ausgewertet. Der Mikrocomputer wiederum liefert in Abhängigkeit vom Pegel des verstärkten Oszillatorsignals ein digitales Regelsignal, das über den Digital-Analog-Converter (DAC) 5 in eine analoge Regelspannung umgewandelt und dem spannungsgesteuerten Oszillator 2 zugeführt wird. Die optimale Abstimmung des Modulators ist erreicht, wenn der Pegel des verstärkten Oszillatorsignals maximal wird.

Die Anordnung gemäß der Erfindung zeichnet sich besonders durch den geringen technischen Aufwand aus, da die zur Abstimmung benutzten Einrichtungen "Tuner" und "Mikrocomputer" in einem Videorecorder ohnehin vorhanden sind. Im Vergleich zu bekannten Modulator-Abstimmschaltungen in Videorecordern kann hierdurch ein vollständiger PLL-Kreis entfallen.

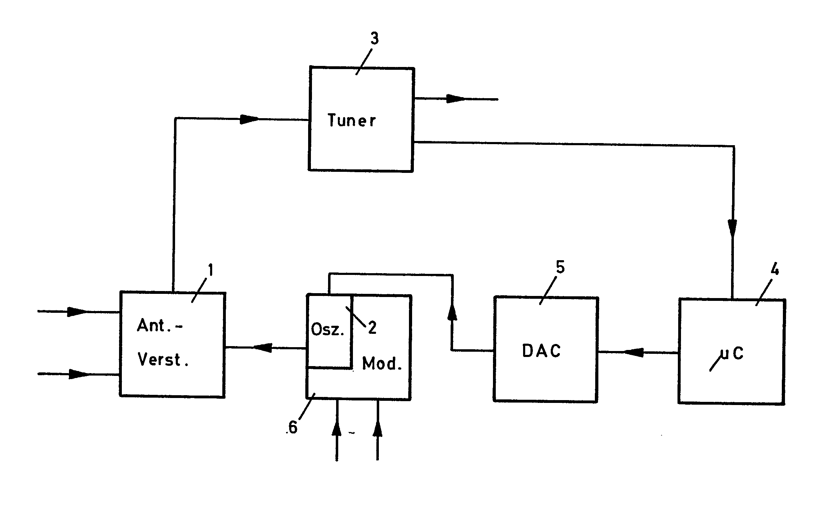

## Ansprüche

1. Verfahren zur Feinabstimmung eines HF-Modulators, der in einem Videorecorder mit automatisch abgleichbarem Tuner betrieben wird und der zur Abstimmung einen spannungsgesteuerten Oszillator enthält, **dadurch gekennzeichnet,** daß das Ausgangssignal des auf einen bestimmten Kanal eingestellten spannungsgesteuerten Oszillators (2) über den entsprechend abgestimmten und abgeglichenen Tuner (3) verstärkt wird, daß der Pegel des verstärkten Oszillatorsignals ausgewertet wird, und daß in Abhängigkeit vom Pegel des verstärkten Oszillatorsignals ein Regelsignal gebildet wird, das die Abstimmung des Modulators (6) solange verändert, bis der Pegel des verstärkten Oszillatorsignals ein Maximum erreicht.

2. Anordnung zur Durchführung des Verfahrens nach Anspruch 1, **dadurch gekennzeichnet,** daß ein Signalweg (1) vorgesehen ist, der den Ausgang des spannungsgesteuerten Oszillators (2) mit dem Eingang des Tuners (3) verbindet, daß ein Mikrocomputer (4) vorgesehen ist, der den Pegel des im Tuner (3) verstärkten Oszillatorsignals auswertet und in Abhängigkeit hiervon ein digitales Regelsignal liefert, und daß ein Digital-Analog-Converter (5) vorgesehen ist, der das digitale Regelsignal in eine analoge Regelspannung umwandelt und diese dem Steuereingang des spannungsgesteuerten Oszillators zuführt.

0 285 926